# EUROPEAN PATENT APPLICATION

(11) **EP 4 654 484 A1**
(43) Date of publication of application: **26.11.2025**
(21) Application number: 23924092.2
(22) Date of filing: 24.02.2023
(51) Int. Cl.: H03M 13/05, H04L 1/00

(54) **ERROR CORRECTION DEVICE, CONTROL CIRCUIT, STORAGE MEDIUM, AND ERROR CORRECTION METHOD**

(71) Applicant: MITSUBISHI ELECTRIC CORPORATION, Chiyoda-ku Tokyo 100-8310 (JP)
(72) Inventor: YOSHIDA, Hideo, Tokyo 100-8310 (JP); ISHII, Kenji, Tokyo 100-8310 (JP); ONOHARA, Kiyoshi, Tokyo 100-8310 (JP)
(74) Representative: Plasseraud IP
(86) International application number: PCT/JP2023/006766
(87) International publication number: WO 2024/176442

(57) **Abstract**

An error correction apparatus (20) that performs two-bit error correction decoding using a block error correcting code includes: a syndrome generation unit (1) that generates a syndrome pattern from a reception sequence; a number-of-errors determination unit (2) that determines a number of bit errors in the reception sequence based on the syndrome pattern; and a two-bit error candidate error correction unit (5) that calculates a first parameter based on the syndrome pattern in a case where the number-of-errors determination unit (2) determines that there is a two-bit error and that there is a possibility of correction of the two-bit error, excepts the first parameter, from the first parameter to be used, based on which the number-of-errors determination unit determines that the two-bit error is uncorrectable, and obtains a normalized root for the two-bit error by using a second parameter obtained by degeneracy of the first parameter by one bit, the first parameter being a constant term of a normalized polynomial and being a normalized parameter, the normalized polynomial being obtained by normalization of a quadratic error locator polynomial.

## Description

### Field

The present disclosure relates to an error correction apparatus, a control circuit, a storage medium, and an error correction method for correcting an error that occurs in wireless communication.

### Background

Conventionally, in two-bit error correction using a block error correcting code such as a Bose-Chaudhuri-Hocquenghem (BCH) code, a quadratic error locator polynomial X²+σ₁X+σ₂, is constructed from syndrome patterns S₁=αⁱ+α^{j} and S₃=α³ⁱ+α^{3j} obtained by syndrome operation, and a root of the quadratic error locator polynomial X²+σ₁X+σ₂ is obtained. Note that αⁱ and α^{j} are Galois field elements corresponding to error locations in a one-to-one relationship, where i≠j and the symbol "+" denotes addition on the Galois field. Furthermore, the following holds: σ₁=αⁱ+α^{j} and σ₂=αⁱ ·α^{j}, where the symbol "·" denotes multiplication on the Galois field.

For example, Patent Literature 1 discloses a technique for obtaining a root by normalizing a quadratic error locator polynomial X²+σ₁X+σ₂ to obtain a normalized polynomial Y²+Y+P, obtaining a root "y" by table lookup using a parameter P as an address, performing multiplication processing or addition processing on the root "y", and obtaining αⁱ and α^{j} indicating error locations. Note that the following holds: P=σ₂/σ₁², where the symbol "/" denotes division on the Galois field. Here, the parameter P is defined such that P= (αⁱ · α^{j}) / (αⁱ+α^{j}) ²=S₃/S₁³+1, and the root "y" is obtained by y=αⁱ/(αⁱ+α^{j}).

### Citation List

### Patent Literature

Patent Literature 1: International Publication No. 01/084719 (WO 01/084719 A1)

### Summary

### Technical Problem

However, according to the above-described conventional technique, the root "y" is output by use of the parameter P as an address in the table lookup for obtaining the root "y" from the parameter P of the normalized polynomial Y²+Y+P. Therefore, for example, in a BCH code having a code length of 255 bits and an information bit length of 239 bits constructed in an extension field on a Galois field GF(2⁸), the parameter P is an 8-bit value, and the root "y" is also an 8-bit value. Thus, a table of 8 bits and 256 words is required. Furthermore, in a BCH code having a code length of 65,535 bits and an information bit length of 65,503 bits constructed in an extension field on a Galois field GF(2¹⁶), the parameter P is a 16-bit value, and the root "y" is also a 16-bit value. Thus, a table of 16 bits and 65,536 words is required. As described above, the above-described conventional technique has a problem in that the tables required for table lookup increase in size, and the circuit scale of an apparatus also increases.

The present disclosure has been made in view of the above, and an object of the present disclosure is to obtain an error correction apparatus capable of preventing an increase in circuit scale.

### Solution to Problem

In order to solve the above-described problems and achieve the object, the present disclosure is an error correction apparatus for performing two-bit error correction decoding using a block error correcting code. The error correction apparatus includes: a syndrome generation unit to generate a syndrome pattern from a reception sequence; a number-of-errors determination unit to determine a number of bit errors in the reception sequence based on the syndrome pattern; and a two-bit error candidate error correction unit to calculate a first parameter based on the syndrome pattern in a case where the number-of-errors determination unit determines that there is a two-bit error and that there is a possibility of correction of the two-bit error, to except the first parameter, from the first parameter to be used, based on which the number-of-errors determination unit determines that the two-bit error is uncorrectable, and to obtain a normalized root for the two-bit error by using a second parameter obtained by degeneracy of the first parameter by one bit, the first parameter being a constant term of a normalized polynomial and being a normalized parameter, the normalized polynomial being obtained by normalization of a quadratic error locator polynomial.

### Advantageous Effects of Invention

The error correction apparatus according to the present disclosure has an effect of enabling circuit scale to be prevented from increasing.

### Brief Description of Drawings

FIG. 1 is a diagram illustrating an exemplary configuration of an error correction apparatus according to a first embodiment.
FIG. 2 is a flowchart illustrating operation of the error correction apparatus according to the first embodiment.
FIG. 3 is a diagram showing, as a comparative example, an example of a table necessary for table lookup to be performed when a root is obtained from a normalized parameter.
FIG. 4 is a diagram showing an example of a degeneracy normalized root table to be used in a degeneracy normalized root acquisition unit included in the error correction apparatus of the first embodiment.
FIG. 5 is a diagram illustrating an exemplary configuration of processing circuitry that implements the error correction apparatus according to the first embodiment, in which the processing circuitry includes a processor and a memory.
FIG. 6 is a diagram showing an example of processing circuitry that implements the error correction apparatus according to the first embodiment, in which the processing circuitry includes dedicated hardware.

### Description of Embodiments

Hereinafter, error correction apparatuses, control circuits, storage media, and error correction methods according to embodiments of the present disclosure will be described in detail with reference to the drawings.

### First Embodiment.

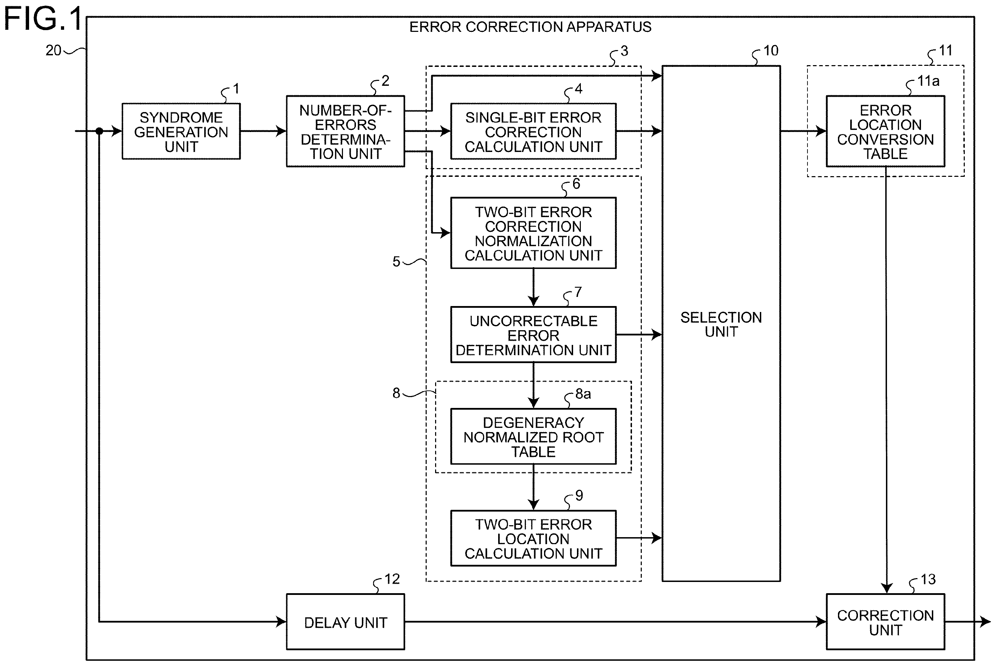

FIG. 1 is a diagram illustrating an exemplary configuration of an error correction apparatus 20 according to a first embodiment. The error correction apparatus 20 is an apparatus that performs two-bit error correction decoding using a block error correcting code such as a BCH code, and corrects an error of two bits or less in an input reception sequence. The error correction apparatus 20 includes a syndrome generation unit 1, a number-of-errors determination unit 2, a determination result processing unit 3, a two-bit error candidate error correction unit 5, a selection unit 10, an error location conversion unit 11, a delay unit 12, and a correction unit 13. The determination result processing unit 3 includes a single-bit error correction calculation unit 4. The two-bit error candidate error correction unit 5 includes a two-bit error correction normalization calculation unit 6, an uncorrectable error determination unit 7, a degeneracy normalized root acquisition unit 8, and a two-bit error location calculation unit 9.

The syndrome generation unit 1 generates syndrome patterns S₁ and S₃ from one of branches of a reception sequence which is input to the error correction apparatus 20. For example, the reception sequence includes, but is not limited to, a reception sequence received through wireless communication by a reception device (not illustrated) including the error correction apparatus 20.

The number-of-errors determination unit 2 determines the number of bit errors in the reception sequence which is input to the error correction apparatus 20, based on the syndrome patterns S₁ and S₃ generated by the syndrome generation unit 1. Specifically, the number-of-errors determination unit 2 determines whether there is no error, a single-bit error, an uncorrectable error, or a two-bit error candidate, based on the syndrome patterns S₁ and S₃. As will be described below, the two-bit error candidate refers to a result of determination to be made by the two-bit error candidate error correction unit 5 as to whether a two-bit error is correctable or uncorrectable, that is, a result of determination that there is a two-bit error and there is a possibility of correction.

The determination result processing unit 3 performs processing on results of determination made by the number-of-errors determination unit 2, other than a determination result of "two-bit error candidate". Specifically, the determination result processing unit 3 performs processing on determination results of "no error", "single-bit error", and "uncorrectable error".

The single-bit error correction calculation unit 4 calculates an element indicating a single-bit error location for the determination result of "single-bit error" made by the number-of-errors determination unit 2.

For the determination result of "two-bit error candidate" made by the number-of-errors determination unit 2, the two-bit error candidate error correction unit 5 calculates elements indicating two-bit error locations when determining that the two-bit error is correctable, or determines that the two-bit error is uncorrectable.

The two-bit error correction normalization calculation unit 6 calculates a normalized parameter P by using a primitive polynomial X⁸+X⁴+X³+X²+1 of an extension field on a Galois field GF(2⁸). The normalized parameter P is a constant term of a normalized polynomial obtained by normalization of a quadratic error locator polynomial, and is a normalized parameter. In the following description, the normalized parameter P may be referred to as a first parameter.

Based on the normalized parameter P calculated by the two-bit error correction normalization calculation unit 6, the uncorrectable error determination unit 7 determines whether a two-bit error candidate is uncorrectable.

When the uncorrectable error determination unit 7 determines that the two-bit error candidate is correctable, the degeneracy normalized root acquisition unit 8 obtains a root "y" from a degeneracy normalized root table 8a in which a parameter P₁ is used as an address. The parameter P₁ is obtained by degeneracy of the normalized parameter P. In the following description, the parameter P₁ may be referred to as a second parameter.

The two-bit error location calculation unit 9 obtains the Galois field elements αⁱ and α^{j} indicating the two-bit error from the root "y" acquired from the degeneracy normalized root acquisition unit 8.

The selection unit 10 selects an output to the error location conversion unit 11 based on a state of each number of errors.

When the output from the selection unit 10 indicates a single-bit error or a two-bit error, the error location conversion unit 11 converts a Galois field element indicating an error location into the error location by using an error location conversion table 11a for converting Galois field elements indicating error locations into the error locations.

The delay unit 12 delays another of the branches of the reception sequence which is input to the error correction apparatus 20 by a processing time corresponding to time from the start of processing performed by the syndrome generation unit 1 until the end of processing performed by the error location conversion unit 11.

The correction unit 13 performs correction of a corresponding bit in the reception sequence delayed by the delay unit 12, on the basis of the error location acquired from the error location conversion unit 11.

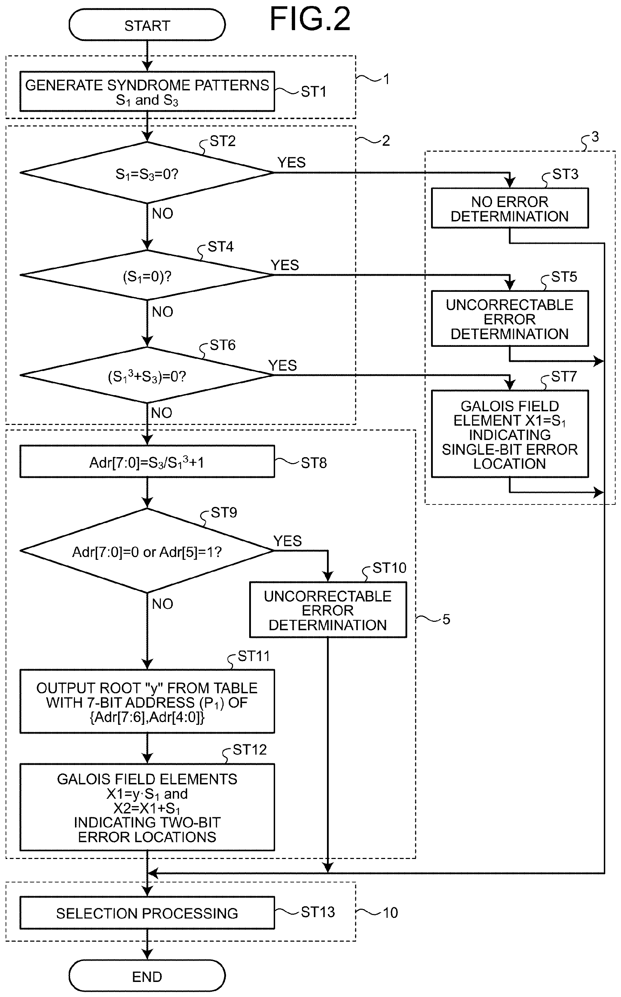

Next, operation of the error correction apparatus 20 will be described. FIG. 2 is a flowchart illustrating operation of the error correction apparatus 20 according to the first embodiment. FIG. 2 is a diagram illustrating operation of the error correction apparatus 20 to be performed in a case where a BCH code is used which is constructed by use of the primitive polynomial X⁸+X⁴+X³+X²+1 in an extension field on the Galois field GF(2⁸) and has a code length of 255 bits and an information bit length of 239 bits, as a specific example. Note that, in FIG. 2, steps from step ST1 to step ST13 are separated by five dotted squares, and reference numerals assigned to the squares correspond to the respective reference numerals of the constituent elements of the error correction apparatus 20 illustrated in FIG. 1. That is, each reference numeral in FIG. 2 indicates a constituent element of the error correction apparatus 20 that performs operation of a corresponding step.

In the error correction apparatus 20, the syndrome generation unit 1 generates the syndrome patterns S₁ and S₃ from one of branches of a reception sequence input to the error correction apparatus 20 (step ST1). The syndrome generation unit 1 outputs the generated syndrome patterns S₁ and S₃ to the number-of-errors determination unit 2.

The number-of-errors determination unit 2 determines the number of errors based on the syndrome patterns S₁ and S₃ generated by the syndrome generation unit 1. Specifically, when S₁=S₃=0 (step ST2: Yes), the number-of-errors determination unit 2 outputs the syndrome patterns S₁ and S₃ and the determination result of "no error" to the determination result processing unit 3. Since the determination result of "no error" has been acquired from the number-of-errors determination unit 2 (step ST3), the determination result processing unit 3 outputs, to the selection unit 10, the syndrome patterns S₁ and S₃ and the determination result of "no error" as they are.

When at least one of S₁ and S₃ is not 0 (step ST2: No) and S₁=0, that is, when S₁=0 and S₃≠0 (step ST4: Yes), the number-of-errors determination unit 2 outputs the syndrome patterns S₁ and S₃ and the determination result of "uncorrectable error" to the determination result processing unit 3. Since the determination result of "uncorrectable error" has been acquired from the number-of-errors determination unit 2 (step ST5), the determination result processing unit 3 outputs, to the selection unit 10, the syndrome patterns S₁ and S₃ and the determination result of "uncorrectable error" as they are.

When S₁≠0 (step ST4: No) and S₁³+S₃=0, that is, when S₁≠0, S₃≠0, and S₁³+S₃=0 (step ST6: Yes), the number-of-errors determination unit 2 outputs the syndrome patterns S₁ and S₃ and the determination result of "single-bit error" to the determination result processing unit 3. Note that the symbol "+" denotes addition on the Galois field. In the determination result processing unit 3, the single-bit error correction calculation unit 4 calculates a Galois field element indicating a single-bit error location for the determination result of "single-bit error" made by the number-of-errors determination unit 2. Specifically, the single-bit error correction calculation unit 4 obtains a Galois field element X1=S₁ indicating a single-bit error location (step ST7), and outputs the Galois field element X1=S₁ to the selection unit 10.

When S₁³+S₃≠0, that is, when S₁≠0, S₃≠0, and S₁³+S₃≠0 (step ST6: No), the number-of-errors determination unit 2 outputs the syndrome patterns S₁ and S₃ and the determination result of "two-bit error candidate" to the two-bit error candidate error correction unit 5.

The two-bit error candidate error correction unit 5 can also obtain a two-bit error location by table lookup using the syndrome patterns S₁ and S₃ as input parameters. However, for example, in the case of the BCH code having a code length of 255 bits and an information bit length of 239 bits, constructed by use of the primitive polynomial X⁸+X⁴+X³+X²+1 in an extension field on the Galois field GF(2⁸), the two-bit error candidate error correction unit 5 needs a table of 16-bit output and 65,536 words.
Therefore, the two-bit error candidate error correction unit 5 performs normalization to reduce the size of a table required for table lookup as compared with the case of obtaining a two-bit error location by using the syndrome patterns S₁ and S₃ as input parameters.

When the number-of-errors determination unit 2 determines that there is a two-bit error candidate, the two-bit error correction normalization calculation unit 6 in the two-bit error candidate error correction unit 5, first, calculates the normalized parameter P=S₃/S₁³+1 based on the syndrome patterns S₁ and S₃ acquired from the number-of-errors determination unit 2 (step ST8). The normalized parameter P=S₃/S₁³+1 is a constant term of a normalized polynomial obtained by normalization of a quadratic error locator polynomial, and is a normalized parameter. The two-bit error correction normalization calculation unit 6 outputs the syndrome patterns S₁ and S₃ and the normalized parameter P obtained by calculation to the uncorrectable error determination unit 7. Note that the symbol "/" denotes division on the Galois field. In addition, the normalized parameter P is represented as "Adr[7:0]" in FIG. 2.

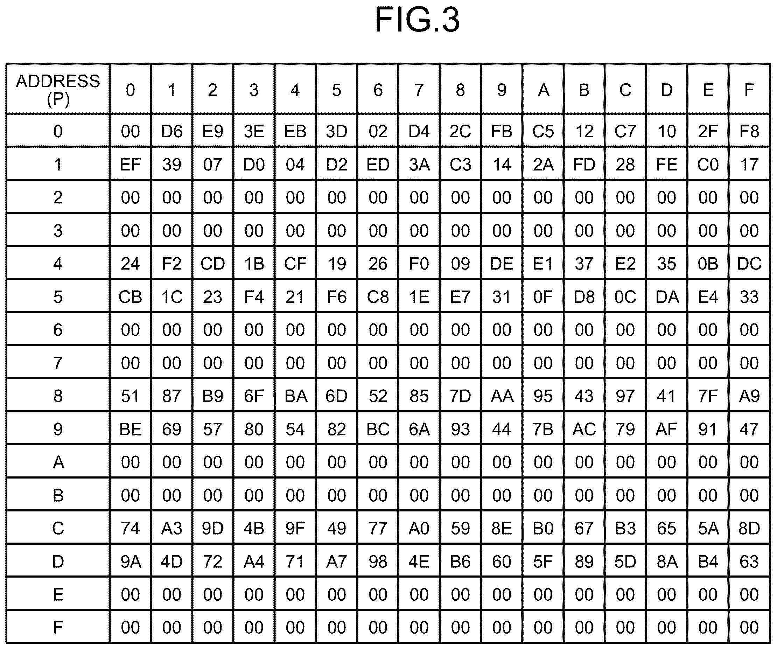

The two-bit error candidate error correction unit 5 can also obtain the root "y" by using the normalized parameter P as an address. In such a case, the primitive polynomial X⁸+X⁴+X³+X²+1 requires, for example, a table as illustrated in FIG. 3. FIG. 3 is a diagram showing, as a comparative example, an example of a table necessary for table lookup to be performed when the root "y" is obtained from the normalized parameter P. In FIG. 3, use of the normalized parameter P as an address is represented as "address (P)". FIG. 3 illustrates the address (P) such that higher-order bits are shown in a vertical direction, and lower four bits are shown in a horizontal direction. Here, the address (P), that is, the normalized parameter P, of an input value that outputs 0 indicates an uncorrectable error. In the present embodiment, focusing on the address (P), that is, the normalized parameter P, in which 0 is output, the uncorrectable error determination unit 7 determines whether a two-bit error candidate is uncorrectable or not, based on the normalized parameter P.

Assuming that the normalized parameter P is an 8-bit address and a least significant bit (LSB) is defined as a zeroth bit, the two-bit error candidate is uncorrectable when P=0 and a fifth bit from the LSB is 1 in the example of FIG. 3. Therefore, in a case where P=0, or in a case where the fifth bit from the LSB is 1 in the normalized parameter P that is an 8-bit address (step ST9: Yes), the uncorrectable error determination unit 7 determines that the two-bit error candidate is uncorrectable (step ST10), and outputs the syndrome patterns S₁ and S₃ and the determination result of "uncorrectable error" to the selection unit 10. Note that, in FIG. 2, a case where P=0 is represented as "Adr[7:0]=0", and a case where the fifth bit from the LSB is 1 is represented as "Adr[5]=1". As a result, the uncorrectable error determination unit 7 regards the case where the fifth bit from the LSB is 1 in the normalized parameter P that is an 8-bit address as a case of an uncorrectable error, and excepts the case from two-bit correction processing in advance. That is, the uncorrectable error determination unit 7 can except the normalized parameter P based on which it is determined that a two-bit error is uncorrectable, from the normalized parameter P to be used in the two-bit error correction processing. In the following description, the LSB may be referred to as a least significant bit.

When P≠0 and the fifth bit from the LSB is not 1 in the normalized parameter P that is an 8-bit address (step ST9: No), the uncorrectable error determination unit 7 determines that the two-bit error candidate is correctable. The uncorrectable error determination unit 7 outputs, to the degeneracy normalized root acquisition unit 8, the syndrome patterns S₁ and S₃ and a result of determination that the two-bit error candidate is correctable. When the uncorrectable error determination unit 7 determines that the two-bit error candidate is correctable, the degeneracy normalized root acquisition unit 8 obtains the root "y" from the degeneracy normalized root table 8a in which the parameter P₁ is used as an address. The parameter P₁ is obtained by degeneracy of the normalized parameter P.

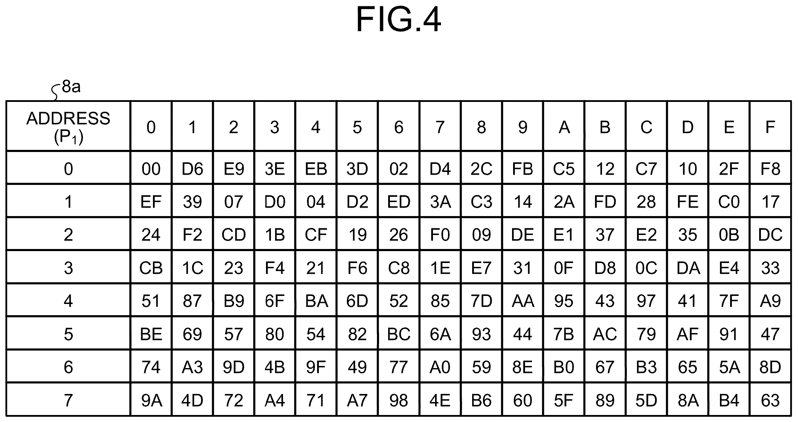

FIG. 4 is a diagram showing an example of the degeneracy normalized root table 8a to be used in the degeneracy normalized root acquisition unit 8 included in the error correction apparatus 20 of the first embodiment. The degeneracy normalized root table 8a illustrated in FIG. 4 is a table for the parameter P₁ which is a 7-bit parameter, obtained based on the table illustrated in FIG. 3 from which the fifth bit from the LSB of the normalized parameter P has been removed. The degeneracy normalized root acquisition unit 8 outputs the root "y" from the degeneracy normalized root table 8a illustrated in FIG. 4 (step ST11). Note that, in FIG. 2, the degeneracy normalized root table 8a is described as "a table with a 7-bit address (P₁) of {Adr[7:6],Adr[4:0]}". The degeneracy normalized root acquisition unit 8 outputs the root "y" and the syndrome patterns S₁ and S₃ to the two-bit error location calculation unit 9. The root "y" defined such that y=αⁱ/(αⁱ+α^{j}) is output from the degeneracy normalized root acquisition unit 8 when the uncorrectable error determination unit 7 determines that the two-bit error candidate is correctable. As described above, the degeneracy normalized root acquisition unit 8 can obtain the normalized root "y" for a two-bit error by using the parameter P₁ obtained by degeneracy of the normalized parameter P by one bit.

The two-bit error location calculation unit 9 calculates Galois field elements indicating two-bit error locations by using the root "y" and the syndrome patterns S₁ and S₃ acquired from the degeneracy normalized root acquisition unit 8. Specifically, the two-bit error location calculation unit 9 obtains Galois field elements X1=αⁱ=y·S₁ and X2=α^{j}=X1+S₁ indicating two-bit error locations (step ST12), and outputs the Galois field elements to the selection unit 10. Note that the symbol "·" denotes multiplication on the Galois field.

The selection unit 10 performs selection processing on a calculation result acquired from the determination result processing unit 3 or the two-bit error candidate error correction unit 5 (step ST13). When acquiring the Galois field element X1=S₁ indicating a single-bit error location from the single-bit error correction calculation unit 4 of the determination result processing unit 3, the selection unit 10 outputs the Galois field element X1=S₁ indicating a single-bit error location to the error location conversion unit 11. When acquiring the Galois field elements X1=αⁱ=y·S₁ and X2=α^{j}=X1+S₁ indicating two-bit error locations from the two-bit error location calculation unit 9 of the two-bit error candidate error correction unit 5, the selection unit 10 outputs the Galois field elements X1=αⁱ=y·S₁ and X2=αⁱ=X1+S₁ indicating two-bit error locations to the error location conversion unit 11.

When acquiring the Galois field element X1=S₁ indicating a single-bit error location or the Galois field elements X1=αⁱ=y·S₁ and X2=αⁱ=X1+S₁ indicating two-bit error locations from the selection unit 10, the error location conversion unit 11 converts the Galois field element or elements indicating an error location or error locations into the error location or locations by using the error location conversion table 11a, and outputs the error location or locations obtained by the conversion to the correction unit 13. Note that, even in a case where it is determined that there is no error or the two-bit error is uncorrectable, the error location conversion unit 11 can perform conversion processing on a location out of an error location range by using the error location conversion table 11a.

The correction unit 13 performs correction of a corresponding bit in the reception sequence delayed by the delay unit 12, on the basis of the error location or error locations acquired from the error location conversion unit 11, that is, inverts the corresponding bit to complete correction, and outputs the corrected reception sequence.

As described above, in the error correction apparatus 20, when the number-of-errors determination unit 2 determines that an error is a two-bit candidate, the two-bit error candidate error correction unit 5 calculates the normalized parameter P based on the syndrome patterns S₁ and S₃. The normalized parameter P is a constant term of a normalized polynomial obtained by normalization of a quadratic error locator polynomial, and is a normalized parameter. The two-bit error candidate error correction unit 5 excepts the normalized parameter P based on which it is determined that a two-bit error is uncorrectable, from the normalized parameter P to be used, and obtains the normalized root "y" for the two-bit error by using the parameter P₁ obtained by degeneracy of the normalized parameter P by one bit. Specifically, in the case of using the primitive polynomial X⁸+X⁴+X³+X²+1 of an extension field on a Galois field, the two-bit error candidate error correction unit 5 determines that a two-bit error is uncorrectable at least when the fifth bit from the LSB is 1 in the normalized parameter P that is a normalized 8-bit parameter, the LSB being defined as a zeroth bit, and obtains the normalized root "y" by using the parameter P₁, the parameter P₁ being obtained by degeneracy of the normalized parameter P from which the fifth bit from the LSB has been removed.

Next, a hardware configuration of the error correction apparatus 20 will be described. In the error correction apparatus 20, the syndrome generation unit 1, the number-of-errors determination unit 2, the determination result processing unit 3, the two-bit error candidate error correction unit 5, the selection unit 10, the error location conversion unit 11, the delay unit 12, and the correction unit 13 are implemented by processing circuitry. The processing circuitry may be a memory and a processor that executes a program stored in the memory, or may be dedicated hardware. The processing circuitry is also referred to as a control circuit.

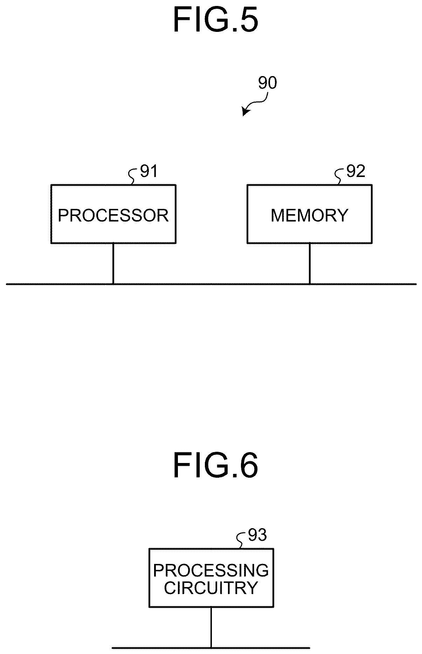

FIG. 5 is a diagram illustrating an exemplary configuration of processing circuitry 90 that implements the error correction apparatus 20 according to the first embodiment, in which the processing circuitry 90 includes a processor 91 and a memory 92. The processing circuitry 90 illustrated in FIG. 5 is a control circuit, and includes the processor 91 and the memory 92. In a case where the processing circuitry 90 includes the processor 91 and the memory 92, each function of the processing circuitry 90 is implemented by software, firmware, or a combination of software and firmware. The software or firmware is described as a program and stored in the memory 92. In the processing circuitry 90, the processor 91 reads and executes the program stored in the memory 92 to implement each function. That is, the processing circuitry 90 includes the memory 92 for storing a program. As a result of execution of the program, the error correction apparatus 20 is caused to perform processing. It can also be said that this program is a program for causing the error correction apparatus 20 to execute each function to be implemented by the processing circuitry 90. This program may be provided by means of a storage medium in which the program has been stored, or may be provided by other means such as a communication medium.

It can also be said that the above-described program is a program for causing the error correction apparatus 20 to perform: a first step of causing the syndrome generation unit 1 to generate the syndrome patterns S₁ and S₃ from a reception sequence; a second step of causing the number-of-errors determination unit 2 to determine the number of bit errors in the reception sequence based on the syndrome patterns S₁ and S₃; and a third step of causing the two-bit error candidate error correction unit 5 to calculate the normalized parameter P based on the syndrome patterns S₁ and S₃ in a case where the number-of-errors determination unit 2 determines that an error is a two-bit error candidate, to except, from the normalized parameter P to be used, the normalized parameter P based on which it is determined that the two-bit error is uncorrectable, and to obtain the normalized root "y" for the two-bit error by using the parameter P₁ obtained by degeneracy of the normalized parameter P by one bit, the normalized parameter P being a constant term of a normalized polynomial and being a normalized parameter, the normalized polynomial being obtained by normalization of a quadratic error locator polynomial.

Here, the processor 91 is, for example, a central processing unit (CPU), a processing device, an arithmetic device, a microprocessor, a microcomputer, or a digital signal processor (DSP). Furthermore, examples of the memory 92 include nonvolatile or volatile semiconductor memories such as a random access memory (RAM), a read only memory (ROM), a flash memory, an erasable programmable ROM (EPROM), and an electrically EPROM (EEPROM (registered trademark)), a magnetic disk, a flexible disk, an optical disk, a compact disk, a mini disk, and a digital versatile disc (DVD).

FIG. 6 is a diagram showing an example of processing circuitry 93 that implements the error correction apparatus 20 according to the first embodiment, in which the processing circuitry 93 includes dedicated hardware. The processing circuitry 93 illustrated in FIG. 6 corresponds to, for example, a single circuit, a composite circuit, a programmed processor, a parallelprogrammed processor, an application specific integrated circuit (ASIC), a field-programmable gate array (FPGA), or a combination thereof. The processing circuitry may be partially implemented by dedicated hardware and partially implemented by software or firmware. Thus, the processing circuitry can implement each of the above-described functions by means of dedicated hardware, software, firmware, or a combination thereof.

As described above, in the processing of a two-bit error correction candidate, the error correction apparatus 20 according to the present embodiment determines in advance that a two-bit error is uncorrectable based on the normalized parameter P, generates the parameter P₁ obtained by simple processing of removing one bit of an input address from the normalized parameter P, and obtains the root "y" based on the parameter P₁. As a result, the error correction apparatus 20 can obtain the root "y" with a table the size of which is half the size of a table to be used in the case of obtaining the root "y" by using the normalized parameter P. Thus, circuit scale can be reduced.

Note that the BCH code having a code length of 255 bits and an information bit length of 239 bits has been described as an example in the present embodiment, but the same processing can also be performed on a 2-bit correction and 3-bit error detection BCH code in which parity has been increased by one bit to have an information bit length of 238 bits.

In addition, the same processing can also be performed on an extended BCH code for 2-bit correction and 3-bit error detection in which parity has been increased by one bit to have a code length of 256 bits and an information bit length of 239 bits.

Furthermore, even in the case of a shortened code in which information bit length has been shortened, the same processing can also be performed as long as the error location conversion unit 11 performs additional processing of determining whether an error is uncorrectable.

### Second Embodiment.

In the first embodiment, for a two-bit error correction candidate with a BCH code having a code length of 255 bits and an information bit length of 239 bits, constructed by use of the primitive polynomial X⁸+X⁴+X³+X²+1 in an extension field on the Galois field GF(2⁸), the error correction apparatus 20 determines in advance that the two-bit error correction candidate is uncorrectable, based on the normalized parameter P, and obtains the root "y" from the degeneracy normalized root table 8a in which the parameter P₁ is used as an address. The degeneracy normalized root table 8a is a table reduced in size to half. The parameter P₁ is obtained by simple processing of degenerating the normalized parameter P by one bit. The error correction apparatus 20 can also use a degeneracy normalized root table reduced in size to half for other primitive polynomials. Meanwhile, whether the parameter P₁, which is obtained by degeneracy of the normalized parameter P by one bit, can be generated by simple processing differs depending on primitive polynomials to be used.

For example, assume that a primitive polynomial X¹⁶+X¹²+X³+X+1 of an extension field GF(2¹⁶) on a Galois field is used in a BCH code having a maximum code length of 65,535 bits or an extended BCH having a maximum code length of 65,536 bits in which extended parity of one bit has been added. In a case where P is a 16-bit address in the normalized parameter P=0, a table for outputting the root "y" is a 16-bit output and 65,536 words. Then, in the case of hexadecimal representation of 2000 to 2FFF, 3000 to 3FFF, 6000 to 6FFF, 7000 to 7FFF, 8000 to 8FFF, 9000 to 9FFF, C000 to CFFF, and D000 to DFFF, all 16-bit roots "y" become 0, and an error is considered uncorrectable. Therefore, the uncorrectable error determination unit 7 of the error correction apparatus 20 performs an operation of exclusive OR of a most significant bit (MSB) and a 13th bit from an LSB, where a second bit from the MSB, that is, the LSB, is defined as a zeroth bit. When the exclusive OR is 1, an error is considered uncorrectable, and the corresponding normalized parameter P is excepted in advance from two-bit correction processing. In the following description, the MSB may be referred to as a most significant bit.

The degeneracy normalized root acquisition unit 8 of the error correction apparatus 20 can obtain the root "y" from a 15-bit parameter P₁ from which the MSB of the normalized parameter P has been removed, by using the degeneracy normalized root table 8a in which data on the root "y" of A000 to BFFF where the root "y" is nonzero in the normalized parameter P has been moved to the output of the root "y" of 2000 to 3FFF and data on the root "y" of E000 to FFFF where the root "y" is nonzero in the normalized parameter P has been moved to the output of the root "y" of 6000 to 7FFF.

As described above, in the case of using the primitive polynomial X¹⁶+X¹²+X³+X+1 of the extension field GF(2¹⁶) on the Galois field, the two-bit error candidate error correction unit 5 determines that a two-bit error is uncorrectable at least when the exclusive OR of the 13th bit from the LSB and the MSB is 1 in the normalized parameter P that is a normalized 16-bit parameter, the LSB being defined as a zeroth bit, and obtains the normalized root "y" by using the parameter P₁, the parameter P₁ being obtained by degeneracy of the normalized parameter P from which the MSB has been removed.

As described above, in the processing of a two-bit error correction candidate of the primitive polynomial X¹⁶+X¹²+X³+X+1 of the extension field GF(2¹⁶) on the Galois field, the error correction apparatus 20 according to the present embodiment determines in advance that a two-bit error is uncorrectable based on the normalized parameter P, generates the parameter P₁ obtained by simple processing of removing one bit of an input address from the normalized parameter P, and obtains the root "y" based on the parameter P₁. As a result, the error correction apparatus 20 can obtain the root "y" with a table the size of which is half the size of a table to be used in the case of obtaining the root "y" by using the normalized parameter P. Thus, circuit scale can be reduced.

Note that, similarly to the first embodiment or the second embodiment, even in a case where primitive polynomials of various extension fields GF(2ⁿ) are used, the error correction apparatus 20 determines in advance that a two-bit error is uncorrectable based on the normalized parameter P, generates the parameter P₁ obtained by simple processing of removing one bit of an input address from the normalized parameter P, and obtains the root "y" based on the parameter P₁. As a result, the error correction apparatus 20 can obtain the root "y" with a table the size of which is half the size of a table to be used in the case of obtaining the root "y" by using the normalized parameter P. Thus, circuit scale can be reduced.

The configurations set forth in the above embodiments show examples, and it is possible to combine the configurations with another known technique or combine the embodiments with each other, and is also possible to partially omit or change the configurations without departing from the scope of the present disclosure.

### Reference Signs List

1 syndrome generation unit; 2 number-of-errors determination unit; 3 determination result processing unit; 4 single-bit error correction calculation unit; 5 two-bit error candidate error correction unit; 6 two-bit error correction normalization calculation unit; 7 uncorrectable error determination unit; 8 degeneracy normalized root acquisition unit; 8a degeneracy normalized root table; 9 two-bit error location calculation unit; 10 selection unit; 11 error location conversion unit; 11a error location conversion table; 12 delay unit; 13 correction unit; 20 error correction apparatus; 90, 93 processing circuitry; 91 processor; 92 memory.

## Claims

1. An error correction apparatus for performing two-bit error correction decoding using a block error correcting code, the error correction apparatus comprising:
a syndrome generation unit to generate a syndrome pattern from a reception sequence;
a number-of-errors determination unit to determine a number of bit errors in the reception sequence based on the syndrome pattern; and
a two-bit error candidate error correction unit to calculate a first parameter based on the syndrome pattern in a case where the number-of-errors determination unit determines that there is a two-bit error and that there is a possibility of correction of the two-bit error, to except the first parameter, from the first parameter to be used, based on which the number-of-errors determination unit determines that the two-bit error is uncorrectable, and to obtain a normalized root for the two-bit error by using a second parameter obtained by degeneracy of the first parameter by one bit, the first parameter being a constant term of a normalized polynomial and being a normalized parameter, the normalized polynomial being obtained by normalization of a quadratic error locator polynomial.

2. The error correction apparatus according to claim 1, wherein
in a case of using a primitive polynomial X⁸+X⁴+X³+X²+1 of an extension field on a Galois field, the two-bit error candidate error correction unit determines that the two-bit error is uncorrectable at least when a fifth bit from a least significant bit is 1 in the first parameter that is a normalized 8-bit parameter, the least significant bit being defined as a zeroth bit, and obtains the normalized root by using the second parameter, the second parameter being obtained by degeneracy of the first parameter from which the fifth bit from the least significant bit has been removed.

3. The error correction apparatus according to claim 1, wherein
in a case of using a primitive polynomial X¹⁶+X¹²+X³+X+1 of an extension field on a Galois field, the two-bit error candidate error correction unit determines that the two-bit error is uncorrectable at least when an exclusive OR of a 13th bit from a least significant bit and a most significant bit is 1 in the first parameter that is a normalized 16-bit parameter, the least significant bit being defined as a zeroth bit, and obtains the normalized root by using the second parameter, the second parameter being obtained by degeneracy of the first parameter from which the most significant bit has been removed.

4. A control circuit for controlling an error correction apparatus that performs two-bit error correction decoding using a block error correcting code, the control circuit causing the error correction apparatus to:
generate a syndrome pattern from a reception sequence;
determine a number of bit errors in the reception sequence based on the syndrome pattern; and
calculate a first parameter based on the syndrome pattern in a case where it is determined that there is a two-bit error and that there is a possibility of correction of the two-bit error, except the first parameter, from the first parameter to be used, based on which it is determined that the two-bit error is uncorrectable, and obtain a normalized root for the two-bit error by using a second parameter obtained by degeneracy of the first parameter by one bit, the first parameter being a constant term of a normalized polynomial and being a normalized parameter, the normalized polynomial being obtained by normalization of a quadratic error locator polynomial.

5. A storage medium with a program stored thereon, the program being for controlling an error correction apparatus that performs two-bit error correction decoding using a block error correcting code, the program causing the error correction apparatus to:
generate a syndrome pattern from a reception sequence;
determine a number of bit errors in the reception sequence based on the syndrome pattern; and
calculate a first parameter based on the syndrome pattern in a case where it is determined that there is a two-bit error and that there is a possibility of correction of the two-bit error, except the first parameter, from the first parameter to be used, based on which it is determined that the two-bit error is uncorrectable, and obtain a normalized root for the two-bit error by using a second parameter obtained by degeneracy of the first parameter by one bit, the first parameter being a constant term of a normalized polynomial and being a normalized parameter, the normalized polynomial being obtained by normalization of a quadratic error locator polynomial.

6. An error correction method to be performed by an error correction apparatus that performs two-bit error correction decoding using a block error correcting code, the error correction method comprising:
a first step of causing a syndrome generation unit to generate a syndrome pattern from a reception sequence;
a second step of causing a number-of-errors determination unit to determine a number of bit errors in the reception sequence based on the syndrome pattern; and
a third step of causing a two-bit error candidate error correction unit to calculate a first parameter based on the syndrome pattern in a case where the number-of-errors determination unit determines that there is a two-bit error and that there is a possibility of correction of the two-bit error, to except the first parameter, from the first parameter to be used, based on which the number-of-errors determination unit determines that the two-bit error is uncorrectable, and to obtain a normalized root for the two-bit error by using a second parameter obtained by degeneracy of the first parameter by one bit, the first parameter being a constant term of a normalized polynomial and being a normalized parameter, the normalized polynomial being obtained by normalization of a quadratic error locator polynomial.
